# EUROPEAN PATENT SPECIFICATION

(11) **EP 2 309 636 B1**
(45) Date of publication and mention of the grant of the patent: **16.07.2014**
(21) Application number: 10173882.1
(22) Date of filing: 24.08.2010
(51) Int. Cl.: H02M 7/162, G01R 27/02, G01R 31/00, G01R 31/02, G01R 31/12, H02P 29/02

(54) **Current leakage detector of construction machine**
Kriechstromdetektor einer Baumaschine
Détecteur de fuite de courant d'une machine de construction

(30) Priority: 07.09.2009 JP 2009206045
(43) Date of publication of application: 13.04.2011
(73) Proprietor: Kobelco Construction Machinery Co. Ltd., Asaminami-ku Hiroshima-shi Hiroshima 731-0138 (JP)
(72) Inventor: Kagoshima, Masayuki, Hiroshima 731-0138 (JP)
(74) Representative: TBK

(56) References cited:
- EP-A1- 1 921 457
- EP-A1- 1 981 143
- EP-A2- 1 614 579
- US-A- 5 686 839
- US-A1- 2008 073 135

## Description

### BACKGROUND OF THE INVENTION

### 1. Field of the Invention

The present invention relates to a current leakage detector for detecting a current leakage in a motor drive circuit in a construction machine in which a motor is driven by a battery.

### 2. Description of the Related Art

Hitherto, regarding the technology for detecting, in a battery-loaded vehicle such as a hybrid car, a current leakage in a motor drive circuit that drives a motor by a battery through an inverter, there is known a technique of applying a test voltage, e.g., a sine wave or a pulse wave, between a circuit bus and a body (ground) and measuring a crest value of the test voltage, as disclosed in Patent Document WO2007/007749.

The known technique utilizes the fact that, if a current leakage occurs due to, e.g., an insulation failure, the crest value of the test voltage is reduced to be lower than a reference value due to generation of current leakage resistance. The occurrence of the current leakage is determined when the crest value lower than the reference value is detected.

However, in a construction machine, particularly a shovel (e.g., a hybrid shovel or a battery shovel), in which a motor is driven by battery power, start/stop of operation of an actuator is frequently repeated, and a battery voltage is abruptly varied whenever the operation of the actuator is started and stopped. Accordingly, the crest value of the test voltage also tends to vary upon receiving an influence of the variation in the battery voltage.

For that reason, if the known technique is directly applied to a motor drive circuit in the construction machine, such as the shovel, there is a high possibility of erroneous detection, for example, that a current leakage state is determined in spite of a current leakage being not actually generated.

Document EP1921457 discloses an insulation resistance drop detector including a pulse generator that applies a pulse signal to a series circuit in which a detecting resistor, a coupling capacitor, and an insulating resistance are serially connected. In a state where the pulse signal is applied to the series circuit, control circuit detects a pulse-like divided voltage occurring at a node by a voltage detecting circuit via a bandpass filter, to thereby sense a drop of an insulation resistance. Further, the control circuit senses a failure of the insulation resistance drop detector itself when the voltage detected by the voltage detecting circuit is maintained at least at a prescribed voltage exceeding a plurality of cycles of the pulse signal.

Document EP1981143 discloses an ECU that determines based on a voltage from an insulation resistance decrease detector whether the insulation resistance of a power supply device decreases or not. When a load external to the vehicle is not connected to the power supply device, the ECU sets a determination threshold value for determining that the insulation resistance decreases to a normal first value. On the other hand, when the load external to the vehicle is electrically connected to the power supply device, the ECU sets the determination threshold value to a second value which is lower than the first value, in consideration of an increase in the capacitive component due to a capacitor of a Y-capacitor.

Document US2008073135 discloses a power output apparatus that generates a commercial AC voltage across neutral points of first and second motor generators. The power output apparatus includes a leakage detecting device, and upon detection of leakage by the leakage detecting device, causes an AC output cutoff circuit to operate and also shuts down one or both of the first and second motor generators according to the operational states at the time. Further, the leakage detecting device performs checking of the leakage detecting function in response to a test signal from a control device, before outputting the commercial AC voltage.

Document US5686839 discloses an equipment and method for detecting electrical leakage in an electric vehicle. For detecting occurrence of leakage in an alternating-current motor for driving the vehicle, a source-side transistor of an inverter is turned ON and a sink-side transistor is turned OFF. When leakage occurs in the motor, there arises an electrical path to an electric leakage detector through the grounded portion from the transistor on the source-side, the motor winding, and the leakage portion. Due to a current flowing in the electrical path, the electrical leakage detector determines that the leakage is present, and the result is notified to the ECU (electronic control unit).

### SUMMARY OF THE INVENTION

The present invention provides a current leakage detector of a construction machine, which can prevent erroneous detection caused by a variation in a battery voltage, and which can reliably detect a current leakage.

According to an aspect of the present invention, there is provided a construction machine as defined in claim 1.

Further aspects of the invention are set out in the dependent claims.

The current leakage detector of the construction machine, according to the present invention, includes a motor drive circuit for driving a motor by a battery through an inverter, signal output means for applying a voltage signal, which is adapted for detection of a current leakage, between the motor drive circuit and a body of the construction machine, signal detection means for detecting the voltage signal applied by the signal output means, motor operation detection means for detecting whether the motor is in an operated state or not, and determination means for determining occurrence or non-occurrence of the current leakage. The determination means determines the occurrence or non-occurrence of the current leakage based on the signal detected by the signal detection means on condition that the non-operated state of the motor is detected by the motor operation detection means.

According to the present invention, since the detection of the current leakage is suspended during the operation of the motor, which causes the variation in the battery voltage, erroneous detection can be prevented and reliable detection of the current leakage can be ensured even in a construction machine, such as a hybrid shovel or a battery shovel, in which the motor operation is frequently started and stopped.

In the above-described constitution of the current leakage detector according to the present invention, preferably, the determination means counts a low crest value time in which a crest value of the voltage signal detected by the signal detection means is not more than a setting value and a high crest value time in which the crest value of the voltage signal detected by the signal detection means exceeds a setting value, determines occurrence of a current leakage state when a count value of the low crest value time is not less than a setting value, determines non-occurrence of the current leakage state when a count value of the high crest value time is not less than a setting value, and interrupts the counting of the low crest value time and the high crest value time when the operation of the motor is detected by the motor operation detection means during the determination.

Further, in the above-described constitution of the current leakage detector according to the present invention, preferably, when the count values of the low crest value time and the high crest value time during a period from start to interruption of the counting are not less than respective setting values, the determination means stores the relevant count values, and when the aforesaid count values are less than the respective setting values, the determination means clears the relevant count values.

Still further, in the above-described constitution of the current leakage detector according to the present invention, preferably, when the interruption of the counting of the low crest value time and the high crest value time continues for a setting time or longer, the determination means clears the relevant count values.

In a preferred embodiment, the determination means counts the low crest value time in which the crest value of the voltage signal detected by the signal detection means is not more than the setting value (i.e., the signal indicating the current leakage state) and the high crest value time in which the crest value of the detected voltage signal is not less than the setting value (i.e., the signal indicating the normal state). If the count value of the low crest value time is not less than the setting value, it is determined that the current leakage state is present, and if the count value of the high crest value time is not less than the setting value, it is determined that the current leakage state is not present. Therefore, the influence of temporary noise can be eliminated and the determination as to the current leakage state or the normal state can be performed with higher reliability.

Moreover, when respective count values of the low crest value time and the high crest value time during the period from start of the counting to its interruption due to the operation of the motor are not less than the setting values, those count values are stored to be ready for restart of the counting after the interruption. If the count values are less than the setting values, those count values are cleared because they are not enough as data for making the determination. In addition, when the interruption of the counting of the low crest value time and the high crest value time continues for the setting time or longer, the count values are cleared on judgment that they are the past data to be discarded. As a result, accuracy in the determination can be increased.

### BRIEF DESCRIPTION OF THE DRAWINGS

Fig. 1 is a block diagram of a drive system and a control system in a hybrid shovel to which the present invention is applied;
Fig. 2 illustrates the system configuration of a current leakage detector for a motor drive circuit according to an embodiment of the present invention; and
Fig. 3 is a flowchart to explain the flow of a determination process in the current leakage detector.

### DESCRIPTION OF THE PREFERRED EMBODIMENTS

In an embodiment described below, the present invention is applied to a hybrid shovel which utilizes engine power and battery power in a combined manner.

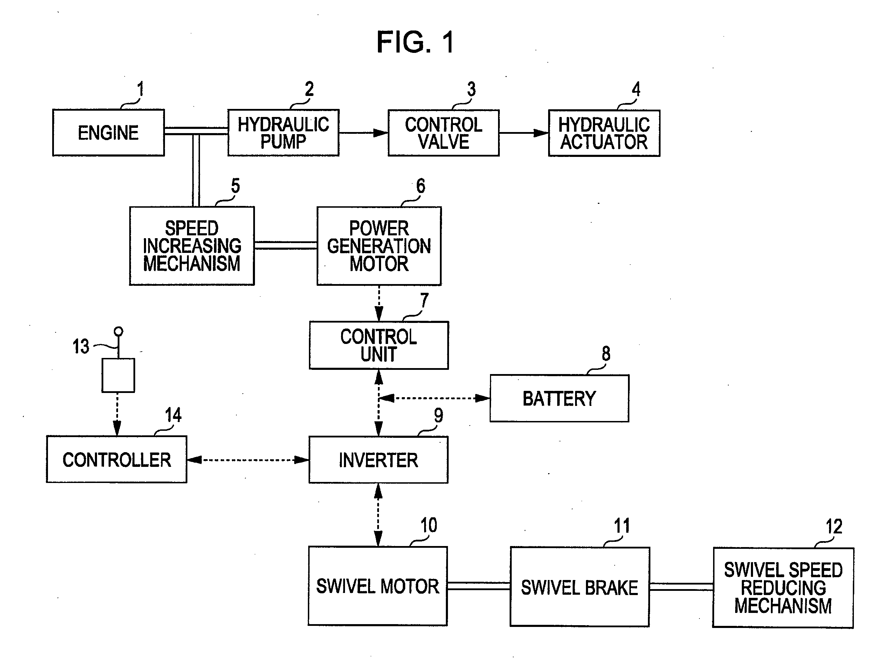

Fig. 1 is a block diagram of a drive system and a control system, which are generally used in the hybrid shovel.

A hydraulic pump 2 is connected to an engine 1, and oil delivered from the hydraulic pump 2 is supplied to a hydraulic actuator 4 (which is representatively illustrated here, although an actual machine includes hydraulic cylinders for a boom, an arm and a bucket and a hydraulic motor for traveling) through a control valve 3.

An output of the engine 1 is applied to a power generation motor 6 through a speed increasing mechanism 5. Electric power produced by the power generation motor 6 is accumulated in a battery 8 through a control unit 7 which controls a voltage and a current. The electric power is further applied to a swivel motor 10 through an inverter 9.

The power generation motor 6 also operates as a motor with the electric power stored in the battery 8, thereby assisting the engine 1 as required.

The swivel motor 10 is provided with a swivel brake 11 for holding the swivel motor 10 in a stopped state. When the swivel brake 11 is in a released state, a rotating force (torque) of the swivel motor 10 is transmitted to an upper swivel structure of the shovel through a swivel speed reducing mechanism 12, whereupon the upper swivel structure is swiveled (rotated) clockwise or counterclockwise.

At that time, a voltage of the battery 8 varies with the rotation of the swivel motor 10. If such a variation in the battery voltage occurs during a later-described process of determining a current leakage, there arises a possibility of erroneous detection.

Reference numeral 13 denotes a swivel operating lever, which serves as one of operating means. In accordance with an operation signal from the operating lever 13, a command signal is output from a controller 14 to the inverter 9, whereupon the swivel motor 10 is controlled.

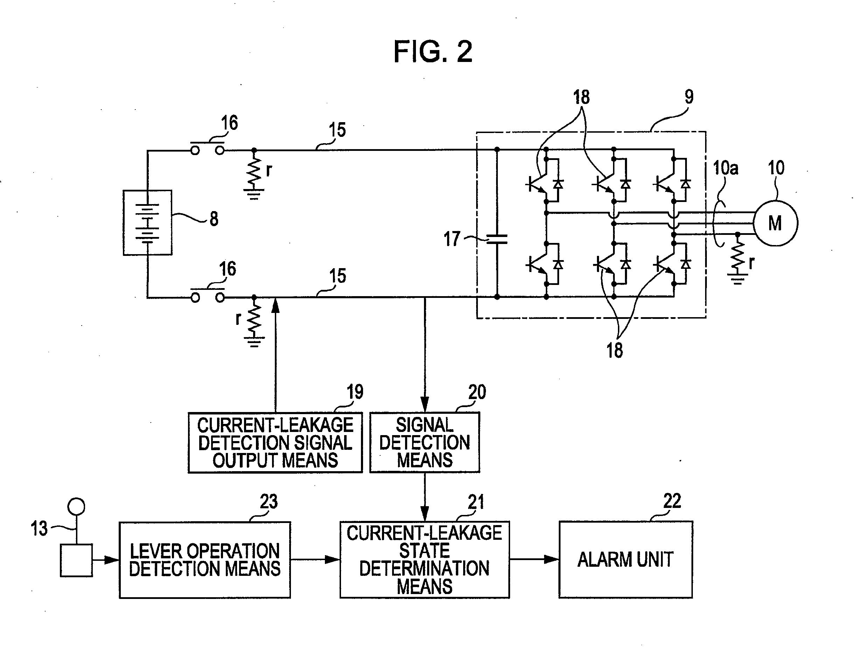

Fig. 2 illustrates the system configuration of a current leakage detector.

The embodiment is constructed so as to detect, in a motor drive circuit for driving the swivel motor 10 by the battery 8 through the inverter 9, a current leakage between the motor drive circuit and a not-shown machine body (ground).

Here, the term "machine body" implies an upper frame of the upper swivel structure in the case of the shovel, the upper frame being grounded through a swivel bearing and a lower traveling structure.

In Fig. 2, reference numerals 15 and 15 denote DC buses of the motor drive circuit, 16 and 16 denote relays (contacts) disposed respectively in the buses 15 and 15 for connection to the battery 8, 17 denotes a capacitor in the inverter 9, 18 denotes a plurality of switching devices, and 10a denotes 3-phase AC lines between the inverter 9 and the swivel motor 10. Further, a reference character r represents current leakage resistance that is generated with a current leakage.

The current leakage detector includes current-leakage detection signal output means 19 for applying a voltage signal (e.g., a pulse voltage at a particular frequency), which is adapted for detection of the current leakage, to the motor drive circuit, specifically between the DC buses 15, 15 and the body, for example, signal detection means 20 for detecting the applied voltage signal, current-leakage state determination means 21, an alarm unit 22 for issuing an alarm in accordance with a signal output from the current-leakage state determination means 21 when the occurrence of the current leakage is determined, and lever operation detection means 23 for detecting whether the operating lever 13 is operated or not.

The current-leakage state determination means 21 determines the occurrence or non-occurrence of the current leakage based on a crest value of the signal detected by the signal detection means 20 and on whether the swivel motor 10 is operated or not.

As described above, the swivel motor 10 is operated in accordance with the operation of the operating lever 13. This implies that whether the swivel motor 10 is operated or not can be indirectly detected by detecting whether the operating lever 13 is operated or not.

In the current leakage detector according to the embodiment, therefore, whether the operating lever 13 is operated or not is detected by using the lever operation detection means (e.g., a potentiometer) 23 instead of detecting the motor operation state, and the detected signal is input, as a motor operation state signal, to the current-leakage state determination means 21.

Taking into account that the crest value of the detected signal (in the form of a pulse voltage) does not exceed a setting value in the current leakage state, but it exceeds the setting value in the current non-leakage state, the current-leakage state determination means 21 counts a time in which the crest value does not exceed the setting value (called a "low crest value time") and a time in which the crest value exceeds the setting value (called a "high crest value time"). Then, the current-leakage state determination means 21 determines that the state current leakage is present, when a count value of the low crest value time is not less than a setting value for the count value of the low crest value time, and determines that the current leakage state is not present (i.e., current non-leakage state = normal state), when a count value of the high crest value time is not less than a setting value for the count value of the high crest value time.

Be it noted that the low crest value time and the high crest value time may be each a time during which the low crest value or the high crest value is continuously detected, or a time derived from the numbers of pulses representing the low crest value or the high crest value.

When the lever operation (i.e., the operation of the motor) is detected by the lever operation detection means 23 during the determination, the counting of the low crest value time and the high crest value time is interrupted (namely, the detection of the current leakage is suspended) in consideration of a risk that erroneous detection may occur due to a variation in the battery voltage.

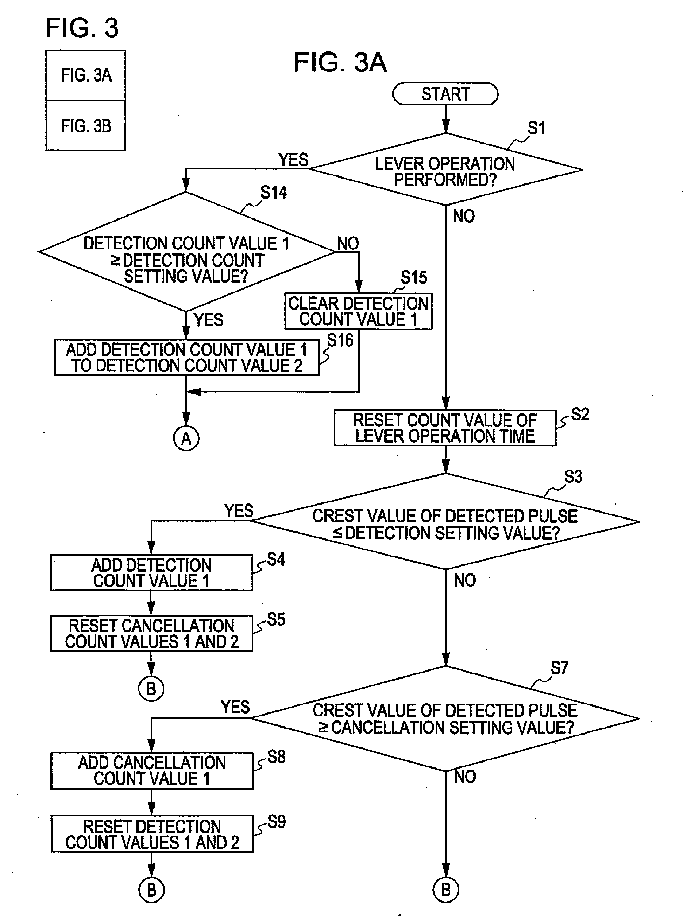

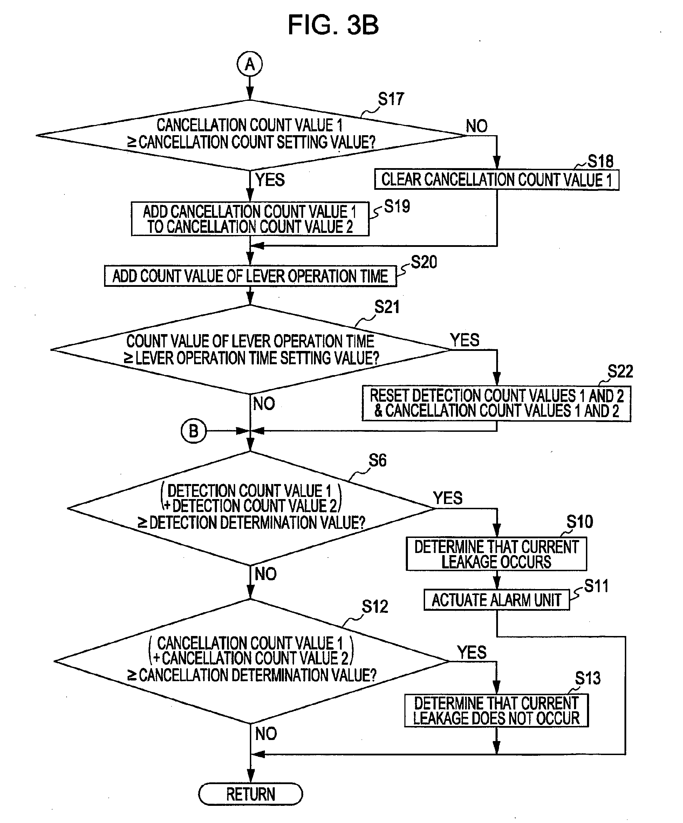

Fig. 3 illustrates details of the current leakage determination process, which is executed by the current-leakage state determination means 21.

### A. When lever operation is not performed during determination

In step S1, whether the lever operation is performed or not is determined. If there is no lever operation ("NO"), the determination process advances to a current leakage detection flow, and if there is the lever operation ("YES"), the determination process advances to a current-leakage detection suspension flow.

In the flow of Fig. 3, the term "count value" implies a count value of the low crest value time or the high crest value time, the term "detection count value" implies a count value of the low crest value time, and the term "detection setting value" implies a threshold set for determining whether the detected crest value is the low crest value or not. Further, the term "cancellation count value" implies a count value of the high crest value time, and the term "cancellation setting value" implies a threshold set for determining whether the detected crest value is the high crest value or not.

Regarding the count value, the term "count value 1" implies a current count value, and the term "count value 2" implies a past count value that has been stored. Further, the term "detection count setting value" implies a threshold set for the detection count value, and the term "cancellation count setting value" implies a threshold set for the cancellation count value.

In the current leakage detection flow, a count value of a lever operation time is first reset in step S2. The flow then shifts to step S3.

In step S3, it is determined whether the crest value of the detected pulse is not more than the detection setting value (i.e., whether it indicates the current leakage state). If the determination result is "YES" (i.e., if the current leakage state is indicated), the detection count value 1 is added in step S4 to count the low crest value time, and the cancellation count values 1 and 2 are reset in step S5. Thereafter, the flow shifts to step S6.

On the other hand, if the determination result in step S3 is "NO" (i.e., crest value of detected pulse > detection setting value), the flow shifts to step S7 in which it is determined whether the crest value of the detected pulse is not less than the cancellation setting value. If the determination result in step S7 is "YES", the flow advances in order of step S8, step S9, and step S6. If the determination result in step S7 is "NO", the flow directly advances to step S6.

In step S8, the cancellation count value 1 is added to count the high crest value time. In step S9, the detection count values 1 and 2 are reset.

In step S6, the count value of the low crest value time (i.e., the total value of the detection count values 1 and 2) is compared with a detection determination value that is a count value as a reference for determining the current leakage state. If the former is not less than the latter, it is determined in step S10 that the current leakage occurs. The alarm unit 23 in Fig. 2 is actuated in step S11 so as to notify an operator of the occurrence of the current leakage. Thereafter, the flow returns to step S1.

On the other hand, if the count value of the low crest value time is less than the detection determination value (if the determination result in step S6 is "NO"), the count value of the high crest value time (i.e., the total value of the cancellation count values 1 and 2) is compared in step S12 with a cancellation determination value that serves as a reference for determining cancellation of the detection of the current leakage. If the former is not less than the latter (i.e., if the determination result in step S12 is "YES"), it is determined in step S13 that the current leakage does not occur. Thereafter, the flow returns to step S1. If the determination result in step S12 is "NO", the flow directly returns to step S1.

### B. When lever operation is performed during determination

If the determination result in step S1 is "YES" (i.e., if the lever operation is performed), the detection of the current leakage is interrupted as follows. First, in step S14, it is determined whether the count value of the low crest value time during a period from start to interruption of the counting (i.e., the detection count value 1) is not less than the detection count setting value that serves as a threshold. If the determination result in step S14 is "NO" (i.e., if the former is less than the latter), the relevant count value is cleared in step S15. If the determination result in step S14 is "YES" (i.e., if the former is not less than the latter), the count value is stored (namely, the detection count value 1 is added to the detection count value 2) in step S16.

In subsequent step S17, it is determined whether the count value of the high crest value time during the period from start to interruption of the counting (i.e., the cancellation count value 1) is not less than the cancellation count setting value that serves as a threshold. If the determination result in step S17 is "NO" (i.e., if the former is less than the latter), the relevant cancellation count value 1 is cleared in step S18. If the determination result in step S17 is "YES" (i.e., if the former is not less than the latter), the count value is stored (namely, the cancellation count value 1 is added to the cancellation count value 2) in step S19.

In step S20, the count value of the lever operation time is added. In step S21, the resulting count value is compared with a lever operation time setting value that is a threshold set for the lever operation time.

If the determination result in step S21 is "YES" (i.e., count value of lever operation time ≥ lever operation time setting value), the detection count values 1 and 2 and the cancellation count values 1 and 2 are reset in step S22, following which the flow shifts to step S6. If the determination result in step S21 is "NO", the flow directly shifts to step S6.

Thus, according to the current leakage detector of the embodiment, the detection of the current leakage is suspended during the operation of the motor 10, which causes the variation in the battery voltage. Therefore, erroneous detection can be prevented and reliable detection of the current leakage can be ensured even in the construction machine, such as the hybrid shovel or the battery shovel, in which the motor operation is frequently started and stopped and for which the embodiment has been described above.

Further, in steps S4 to S12, the low crest value time in which the crest value of the detected pulse voltage is not more than the setting value (i.e., the signal indicating the current leakage state) and the high crest value time in which the crest value of the detected pulse voltage is not less than the setting value (i.e., the signal indicating the normal state) are counted. If the count value of the low crest value time is not less than the setting value, it is determined that the current leakage state is present, and if the count value of the high crest value time is not less than the setting value, it is determined that the current leakage state is not present. Therefore, the influence of temporary noise can be eliminated and the determination as to the current leakage state or the normal state can be performed with higher reliability.

Moreover, in steps S14 to S21, if respective count values of the low crest value time and the high crest value time during the period from start of the counting to its interruption due to the operation of the motor are not less than the setting values, those count values are stored to be ready for restart of the counting after the interruption.

If the count values are less than the setting values, those count values are cleared because they are not enough as data for making the determination. In addition, if the interruption of the counting of the low crest value time and the high crest value time continues for a setting time or longer, the count values are cleared on judgment that they are the past data to be discarded. As a result, accuracy in the determination can be increased.

### Other Embodiments

(1) When the power generation motor 6 operates as a motor (to assist the engine) with the battery power, the battery voltage also varies, thus causing a possibility of erroneous detection of the current leakage. Therefore, the determination as to the current leakage may be suspended during the operation of the power generation motor 6.
(2) The present invention can be applied to not only the hybrid shovel, but also to a battery shovel employing only a battery as a power source and other battery-loaded construction machines than the shovels in a similar manner to that in the embodiment described above.

Although the invention has been described with reference to the preferred embodiments in the attached figures, it is noted that equivalents may be employed and substitutions made herein without departing from the scope of the invention as recited in the claims.

In a construction machine in which a motor is driven by battery power through an inverter in accordance with operation of an operating lever, current-leakage detection signal output means applies a voltage signal, which is adapted for detection of a current leakage, between DC buses connected to the battery and a body of the machine. The applied signal voltage is detected by signal detection means, and the occurrence or non-occurrence of a current leakage is determined based on a crest value of the detected voltage signal. When the operating lever is operated during the determination, the determination is suspended to prevent erroneous detection.

## Claims

1. A current leakage detector of a construction machine comprising:
a motor drive circuit for driving a motor (10) by a battery (8) through an inverter (9);
signal output means (19) for applying a voltage signal, which is adapted for detection of a current leakage, between the motor drive circuit and a body of the construction machine;
signal detection means (20) for detecting the voltage signal applied by the signal output means; and
motor operation detection means (23) for detecting whether the motor is in an operated state or not;
**characterized by**
determination means (21) for determining occurrence or non-occurrence of the current leakage, the determination means determining the occurrence or non-occurrence of the current leakage based on the signal detected by the signal detection means (20) on condition that the non-operated state of the motor is detected by the motor operation detection means (23),
wherein the determination means (21) counts a low crest value time in which a crest value of the voltage signal detected by the signal detection means (20) is not more than a setting value and a high crest value time in which the crest value of the voltage signal detected by the signal detection means exceeds a setting value, determines occurrence of a current leakage state when a count value of the low crest value time is not less than a setting value, determines non-occurrence of the current leakage state when a count value of the high crest value time is not less than a setting value, and interrupts the counting of the low crest value time and the high crest value time when the operation of the motor is detected by the motor operation detection means (23) during the determination.

2. The current leakage detector of the construction machine according to Claim 1, wherein when the count values of the low crest value time and the high crest value time during a period from start to interruption of the counting are not less than respective setting values, the determination means (21) stores the relevant count values, and when the aforesaid count values are less than the respective setting values, the determination means clears the relevant count values.

3. The current leakage detector of the construction machine according to Claim 1, wherein when the interruption of the counting of the low crest value time and the high crest value time continues for a setting time or longer, the determination means (21) clears the relevant count values.

## Patentansprüche

1. Kriechstromdetektor einer Baumaschine, mit:
einer Motorantriebsschaltung zum Antreiben eines Motors (10) durch eine Batterie (8) über einen Inverter (9);
einer Signalausgabeeinrichtung (19) zum Anlegen eines Spannungssignals, das zur Erfassung eines Kriechstroms angepasst ist, zwischen der Motorantriebsschaltung und einer Karosserie der Baumaschine;
einer Signalerfassungseinrichtung (20) zum Erfassen des Spannungssignals, das durch die Signalausgabeeinrichtung angelegt wird; und
einer Motorbetriebserfassungseinrichtung (23) zum Erfassen, ob sich der Motor in einem Betriebszustand befindet oder nicht;
**gekennzeichnet durch**
eine Bestimmungseinrichtung (21) zum Bestimmen eines Auftretens oder Nichtauftretens des Kriechstroms, wobei die Bestimmungseinrichtung das Auftreten oder Nichtauftreten des Kriechstroms basierend auf dem Signal, das **durch** die Signalerfassungseinrichtung (20) erfasst wird, bestimmt, unter der Bedingung, dass der Nichtbetriebszustand des Motors **durch** die Motorbetriebserfassungseinrichtung (23) erfasst wird,
wobei die Bestimmungseinrichtung (21) eine Zeit eines niedrigen Scheitelwerts, bei der ein Scheitelwert des Spannungssignals, das **durch** die Signalerfassungseinrichtung (20) erfasst wird, nicht mehr als ein Einstellwert ist, und eine Zeit eines hohen Scheitelwerts, bei der der Scheitelwert des Spannungssignals, der **durch** die Signalerfassungseinrichtung erfasst wird, einen Einstellwert überschreitet, zählt, ein Auftreten eines Kriechstromzustands bestimmt, wenn ein Zählwert der Zeit eines niedrigen Scheitelwerts nicht weniger als ein Einstellwert ist, ein Nichtauftreten des Kriechstromzustands bestimmt, wenn ein Zählwert der Zeit eines hohen Scheitelwerts nicht weniger als ein Einstellwert ist, und das Zählen der Zeit eines niedrigen Scheitelwerts und der Zeit eines hohen Scheitelwerts unterbricht, wenn der Betrieb des Motors **durch** die Motorbetriebserfassungseinrichtung (23) während der Bestimmung erfasst wird.

2. Kriechstromdetektor der Baumaschine gemäß Anspruch 1, wobei, wenn die Zählwerte der Zeit eines niedrigen Scheitelwerts und der Zeit eines hohen Scheitelwerts während einer Periode von einem Start bis zur Unterbrechung des Zählens nicht weniger als entsprechende Einstellwerte sind, die Bestimmungseinrichtung (21) die relevanten Zählwerte speichert, und wenn die vorstehend genannten Zählwerte weniger als die entsprechenden Einstellwerte sind, die Bestimmungseinrichtung die relevanten Zählwerte löscht.

3. Kriechstromdetektor der Baumaschine gemäß Anspruch 1, wobei, wenn die Unterbrechung des Zählens der Zeit eines niedrigen Scheitelwerts und der Zeit eines hohen Scheitelwerts für eine Einstellzeit oder länger fortgesetzt wird, die Bestimmungseinrichtung (21) die relevanten Zählwerte löscht.

## Revendications

1. Détecteur de fuite de courant d'une machine de construction comprenant :
un circuit d'entraînement de moteur destiné à entraîner un moteur (10) par une batterie (8) au moyen d'un onduleur (9) ;
un moyen de sortie de signal (19) destiné à appliquer un signal de tension, qui est adapté pour la détection d'une fuite de courant, entre le circuit d'entraînement de moteur et un corps de la machine de construction ;
un moyen de détection de signal (20) destiné à détecter le signal de tension appliqué par le moyen de sortie de signal ; et
un moyen de détection de fonctionnement de moteur (23) destiné à détecter si le moteur est dans un état de fonctionnement ou non ;
**caractérisé par**
un moyen de détermination (21) destiné à déterminer l'occurrence ou la non-occurrence de la fuite de courant, le moyen de détermination déterminant l'occurrence ou la non-occurrence de la fuite de courant sur la base du signal détecté par le moyen de détection de signal (20) à condition que l'état de non-fonctionnement du moteur soit détecté par le moyen de détection de fonctionnement de moteur (23),
dans lequel le moyen de détermination (21) compte un temps de valeur de crête faible pendant lequel une valeur de crête du signal de tension détecté par le moyen de détection de signal (20) ne dépasse pas une valeur de réglage et un temps de valeur de crête élevée pendant lequel la valeur de crête du signal de tension détecté par le moyen de détection de signal dépasse une valeur de réglage, détermine l'occurrence d'un état de fuite de courant lorsqu'une valeur de comptage du temps de valeur de crête faible n'est pas inférieure à une valeur de réglage, détermine la non-occurrence de l'état de fuite de courant lorsqu'une valeur de comptage du temps de valeur de crête élevée n'est pas inférieure à une valeur de réglage, et interrompt le comptage du temps de valeur de crête faible et du temps de valeur de crête élevée lorsque le fonctionnement du moteur est détecté par le moyen de détection de fonctionnement de moteur (23) pendant la détermination.

2. Détecteur de fuite de courant de la machine de construction selon la revendication 1, dans lequel, lorsque les valeurs de comptage du temps de valeur de crête faible et du temps de valeur de crête élevée pendant une période allant du début jusqu'à l'interruption du comptage ne sont pas inférieures à de valeurs de réglage respectives, le moyen de détermination (21) stocke les valeurs de comptage pertinentes, et lorsque les valeurs de comptage susmentionnées sont inférieures aux valeurs de réglage respectives, le moyen de détermination efface les valeurs de comptage pertinentes.

3. Détecteur de fuite de courant de la machine de construction selon la revendication 1, dans lequel, lorsque l'interruption du comptage du temps de valeur de crête faible et du temps de valeur de crête élevée se poursuit pendant un temps de réglage ou un temps plus long, le moyen de détermination (21) efface les valeurs de comptage pertinentes.
